# EUROPÄISCHE PATENTSCHRIFT

(11) **EP 2 923 146 B1**
(45) Veröffentlichungstag und Bekanntmachung des Hinweises auf die Patenterteilung: **18.01.2017**
(21) Anmeldenummer: 13792662.2
(22) Anmeldetag: 15.11.2013
(51) Int. Cl.: F21V 3/02, F21V 23/00, F21K 9/20, F21V 19/00, F21Y 115/10

(54) **OPTOELEKTRONISCHE BAUGRUPPE UND VERFAHREN ZUM HERSTELLEN EINER OPTOELEKTRONISCHEN BAUGRUPPE**
OPTOELECTRONIC ASSEMBLY AND METHOD FOR PRODUCING AN OPTOELECTRONIC ASSEMBLY
SOUS-ENSEMBLE OPTOÉLECTRONIQUE ET PROCÉDÉ DE FABRICATION D'UN SOUS-ENSEMBLE OPTOÉLECTRONIQUE

(30) Priorität: 20.11.2012 DE 102012221229
(43) Veröffentlichungstag der Anmeldung: 30.09.2015
(73) Patentinhaber: OSRAM GmbH, 80807 München (DE)
(72) Erfinder: PREUSCHL, Thomas, 93161 Sinzing (DE); KRAUS, Robert, 93051 Regensburg (DE)
(86) Internationale Anmeldenummer: PCT/EP2013/073966
(87) Internationale Veröffentlichungsnummer: WO 2014/079784

(56) Entgegenhaltungen:
- EP-A1- 2 503 214
- WO-A1-2007/108600
- WO-A1-2011/043441
- WO-A1-2012/055852
- US-A1- 2008 123 341

## Beschreibung

Die Erfindung betrifft eine optoelektronische Baugruppe und ein Verfahren zum Herstellen einer optoelektronischen Baugruppe.

Die WO 2012/055852 A1 zeigt ein LED-Modul, bei dem LEDs auf eine Träger montiert sind, der wiederum auf einer Trägerplatte angebracht ist, wobei die Trägerplatte an einer weiteren Leiterplatte über Pins, die Bestandteil eines Gehäuses sind, fixiert ist.

Eine herkömmliche optoelektronische Baugruppe kann beispielsweise ein Gehäuse, eine Leiterplatte, ein auf der Leiterplatte angeordnetes elektronisches Bauelement, einen Träger und/oder ein auf dem Träger angeordnetes optoelektronisches Bauelement auf einem Substrat, beispielsweise in Form einer Untergruppe ("Submount"), aufweisen. Das Gehäuse dient beispielsweise als Schutz für das elektronische Bauelement, für elektrisch leitfähige Leiterbahnen der Leiterplatte und/oder Anschlüsse der optoelektronischen Baugruppe gegen äußere Einwirkungen, wie beispielsweise Stöße und/oder Feuchtigkeit. Das Gehäuse kann beispielsweise mittels Klebens und/oder einer Steck- oder Rastverbindung an der Leiterplatte und/oder dem Träger befestigt werden. Zum Verbessern des Schutzes gegen Feuchtigkeit kann beispielsweise ein Dichtkörper, wie beispielsweise eine Silikonkappe zwischen dem Gehäuse und der Leiterplatte und/oder dem elektronischen Bauelement angeordnet werden. Der Träger kann beispielsweise zum Tragen der Leiterplatte und/oder des Substrats mit dem optoelektronischen Bauelement und/oder als Wärmesenke und/oder zum Stabilisieren der optoelektronischen Baugruppe dienen.

Das optoelektronische Bauelement der Untergruppe kann beispielsweise zwischen 1 und 500, beispielsweise zwischen 100 und 200 LEDs aufweisen, die beispielsweise elektrisch miteinander gekoppelt sein können. Ferner kann die Untergruppe das Substrat, beispielsweise ein Keramiksubstrat und/oder ein Metallsubstrat, aufweisen, auf dem die LEDs angeordnet sind. Ferner kann das optoelektronische Bauelement eine Konversionsschicht zum Konvertieren von mittels der LEDs erzeugter elektromagnetischer Strahlung aufweisen. Die Konversionsschicht kann beispielsweise von einer Leuchtstoff aufweisenden Silikonschicht gebildet sein. Das Substrat mit dem optoelektronischen Bauelement kann beispielsweise auf dem Träger befestigt werden, beispielsweise mittels eines Haftmittels, beispielsweise eines Wärmeklebers. Der Wärmekleber kann beispielsweise in einem Dispensverfahren auf den Träger und/oder das optoelektronische Bauelement aufgebracht werden und/oder bei 100° bis 200° C getrocknet und/oder gehärtet werden.

Die Leiterplatte kann beispielsweise auf dem Träger ausgebildet werden. Beispielsweise können Schichten der Leiterplatte auf den Träger laminiert werden. Das optoelektronische Bauelement kann beispielsweise über das Substrat mittels elektrisch isolierter Drähte mit der Leiterplatte, beispielsweise mit den Leiterbahnen der Leiterplatte, elektrisch kontaktiert werden.

Nach Fertigstellung kann die optoelektronische Baugruppe dann ihrerseits an einer Montagefläche montiert werden, beispielsweise mittels Klipsen, Schrauben, Nieten oder ähnlichem. Beispielsweise zum Festschrauben können Montageausnehmungen in der optoelektronischen Baugruppe vorgesehen sein, die sich beispielsweise durch das Gehäuse, den Träger und die Leiterplatte hindurch erstrecken können. Ferner können die Montageausnehmungen mittels Hülsen verstärkt sein, um die mechanischen Belastungen, wie beispielsweis Druck oder Spannungskräfte, bei der Montage aufnehmen zu können.

Die optoelektronische Baugruppe kann beispielsweise dem Zhaga-Standard entsprechen und/oder den Zhaga-Standard erfüllen. In dem Zhaga-Standard sind beispielsweise klar definierte Schnittstellen-Spezifikationen festlegt. Dies gewährleistet die Austauschbarkeit von LED-Lichtquellen verschiedener Hersteller.

In verschiedenen Ausführungsformen wird eine optoelektronische Baugruppe bereitgestellt, die einfach, schnell und/oder kostengünstig herstellbar ist und/oder bei der ein optoelektronisches Bauelement der optoelektronischen Baugruppe einfach, schnell und/oder kostengünstig elektrisch kontaktierbar ist.

In verschiedenen Ausführungsformen wird ein Verfahren zum Herstellen einer optoelektronischen Baugruppe bereitgestellt, das einfach, schnell und/oder kostengünstig durchführbar ist und/oder bei dem ein optoelektronisches Bauelement der optoelektronischen Baugruppe einfach, schnell und/oder kostengünstig elektrisch kontaktierbar ist.

In verschiedenen Ausführungsformen wird eine optoelektronische Baugruppe bereitgestellt. Die optoelektronische Baugruppe weist ein Substrat auf. Das Substrat weist an einer ersten Seite des Substrats einen ersten Kontaktbereich auf. Ein optoelektronisches Bauelement ist auf der ersten Seite des Substrats angeordnet und weist einen ersten Kontakt, der elektrisch mit dem ersten Kontaktbereich gekoppelt ist, auf. Eine Leiterplatte weist Leiterbahnen auf und ist an einer ersten Seite der Leiterplatte mit der ersten Seite des Substrats körperlich gekoppelt. Die Leiterplatte weist eine zentrale Ausnehmung, in der das optoelektronische Bauelement freigelegt ist, und eine erste Kontaktausnehmung, die den ersten Kontaktbereich überlappt, auf. Mindestens ein elektronisches Bauelement ist auf einer zweiten Seite der Leiterplatte, die von der ersten Seite der Leiterplatte abgewandt ist, angeordnet und ist mit mindestens einer der Leiterbahnen elektrisch gekoppelt. Ein elektrisch leitfähiges erstes Verbindungselement ist in der ersten Kontaktausnehmung angeordnet und koppelt den ersten Kontaktbereich mit mindestens einer der Leiterbahnen elektrisch. Das Verbindungselement legt das Substrat an der Leiterplatte fest.

Die über dem Kontaktbereich des Substrats angeordnete Kontaktausnehmung der Leiterplatte und das Verbindungselement, das in der Kontaktausnehmung angeordnet ist und das das elektronische Bauelement und/oder die Leiterbahn durch die Leiterplatte hindurch mit dem Kontaktbereich zum Kontaktieren des optoelektronischen Bauelements elektrisch kontaktiert, tragen zu einem einfachen, schnellen und kostengünstigen Herstellen der optoelektronischen Baugruppe und/oder zu einem einfachen, schnellen und kostengünstigen elektrischen Kontaktieren des optoelektronischen Bauelements bei. Beispielsweise kann auf Drähte, beispielsweise Bonddrähte oder Isolierdrähte zum elektrischen Koppeln des optoelektronischen Bauelements mit der Leiterplatte verzichtet werden. Ferner kann die Untergruppe ("Submount"), insbesondere das Substrat, ohne Träger, beispielsweise ohne Aluminiumträger, mit der Leiterplatte gekoppelt werden. In anderen Worten kann die Untergruppe mit dem optoelektronischen Bauelement direkt körperlich mit der Leiterplatte gekoppelt werden und/oder auf den Träger kann verzichtet werden. Das Substrat dient beispielsweise zum direkten Anordnen von Chips, beispielsweise Halbleiter-Chips, beispielsweise LEDs auf dem Substrat.

Das Substrat kann beispielsweise an der ersten Seite des Substrats einen zweiten Kontaktbereich aufweisen. Das optoelektronische Bauelement kann einen zweiten Kontakt, der mit dem zweiten Kontaktbereich elektrisch gekoppelt ist, aufweisen. Die Leiterplatte kann eine zweite Kontaktausnehmung aufweisen, die den zweiten Kontaktbereich überlappt. Ein elektrisch leitfähiges zweites Verbindungselement kann in der zweiten Kontaktausnehmung angeordnet sein und den zweiten Kontaktbereich mit mindestens einer der Leiterbahnen elektrisch koppeln. Das zweite Verbindungselement kann das Substrat an der Leiterplatte festlegen.

Gemäß verschiedenen Ausführungsformen hat die optoelektronische Baugruppe ein Gehäuse, das zumindest einen Teil der zweiten Seite der Leiterplatte und das elektronische Bauelement abdeckt. Das Gehäuse weist eine zentrale Ausnehmung des Gehäuses auf, in der das optoelektronische Bauelement freigelegt ist. Das Gehäuse kann zum Befestigen der optoelektronischen Baugruppe beispielsweise eine Montageausnehmung des Gehäuses aufweisen. Die Leiterplatte kann eine Montageausnehmung der Leiterplatte aufweisen, die die Montageausnehmung des Gehäuses zumindest teilweise überlappt. Beispielsweise können die Montageausnehmungen des Gehäuses und der Leiterplatte konzentrisch und/oder mit gleichem Radius ausgebildet sein. Die Montageausnehmungen ermöglichen ein einfaches Montieren der optoelektronischen Baugruppe, beispielsweise an einer Montagefläche. Das Gehäuse kann beispielsweise in einem Spritzgussverfahren hergestellt sein.

Gemäß verschiedenen Ausführungsformen erstreckt sich eine Wandung der Montageausnehmung des Gehäuses durch die Montageausnehmung der Leiterplatte hindurch und neben dem Substrat bis hin zu einer zweiten Seite des Substrats, die von der ersten Seite des Substrats abgewandt ist. In anderen Worten kann ein Endabschnitt der Wandung der Montageausnehmung des Gehäuses mit der zweiten Seite des Substrats bündig sein. Beispielsweise können die zweite Seite des Substrats und der Endabschnitt der Wandung der Montageausnehmung des Gehäuses eine Unterseite der optoelektronischen Baugruppe bilden, wobei die optoelektronische Baugruppe elektromagnetische Strahlung an einer von der Unterseite abgewandten Oberseite der optoelektronischen Baugruppe emittiert. Die sich bis zu der zweiten Seite des Substrats erstreckende Wandung der Montageausnehmung des Gehäuses kann dazu beitragen, dass bei der Montage der optoelektronischen Baugruppe wenig mechanischer Stress, beispielsweise Verbiegungskräfte, auf die optoelektronische Baugruppe, beispielsweise das Substrat und/oder die Leiterplatte, wirken.

Gemäß verschiedenen Ausführungsformen weist die Leiterplatte eine Montageausnehmung der Leiterplatte auf und das Substrat weist eine Montageausnehmung des Substrats auf, die die Montageausnehmung der Leiterplatte überlappt. Ferner überlappen die Montageausnehmung der Leiterplatte und des Substrats mit der Montageausnehmung des Gehäuses. Beispielsweise sind alle sich überlappenden Montageausnehmungen konzentrisch und/oder mit gleichem Radius ausgebildet. Beispielsweise bilden die überlappenden Montageausnehmungen eine durchgehende Montageausnehmung der optoelektronischen Baugruppe. Die Montageausnehmung des Substrats kann dazu beitragen, auf die sich bis zur zweiten Seite des Substrats hin erstreckende Wandung der Montageausnehmung des Gehäuses verzichten zu können und dass dennoch bei der Montage der optoelektronischen Baugruppe wenig mechanischer Stress, beispielsweise Verbiegungskräfte, auf die optoelektronische Baugruppe, beispielsweise das Substrat und/oder die Leiterplatte, wirken.

Gemäß verschiedenen Ausführungsformen ist in der Montageausnehmung des Gehäuses eine Hülse angeordnet. Die Hülse kann beispielsweise ein Metall oder einen harten Kunststoff aufweisen oder daraus gebildet sein. Die Hülse kann bei der Montage entstehende Kräfte, beispielsweise aufgrund einer Schraubverbindung, aufnehmen, wodurch das Gehäuse entlastet wird. Falls sich die Wandung der Montageausnehmung des Gehäuses bis zu der zweiten Seite des Substrats hin erstreckt, so kann sich auch die Hülse bis hin zu der zweiten Seite des Substrats hin erstrecken. Falls die Montageausnehmung des Substrats ausgebildet ist, so kann sich die Hülse bis durch die Montageausnehmung der Leiterplatte und/oder bis durch die Montageausnehmung des Substrats erstrecken.

Gemäß verschiedenen Ausführungsformen weist das Gehäuse einen Befestigungsstift auf und die Leiterplatte weist eine Befestigungsausnehmung auf. Zumindest ein Abschnitt des Befestigungsstifts ist in der Befestigungsausnehmung angeordnet. Der Abschnitt des Befestigungsstifts und die Befestigungsausnehmung sind mit einer Presspassung zueinander ausgebildet. Der Befestigungsstift und die Befestigungsausnehmung können dazu beitragen, das Gehäuse einfach und schnell an der Leiterplatte zu befestigen.

Gemäß verschiedenen Ausführungsformen weist das Verbindungselement Lot auf. Das Lot kann einfach in die Kontaktausnehmungen eingebracht werden. Ferner kann das Lot einfach geschmolzen werden, beispielsweise mittels lokaler Erwärmung des Substrats und/oder des Lots. Das Lot kann auf einfache Weise dazu beitragen, die elektrische und körperliche Verbindung zwischen den Kontaktbereichen und den Leiterbahnen und/oder dem elektronischen Bauelement herzustellen.

In verschiedenen Ausführungsformen wird ein Verfahren zum Herstellen einer optoelektronischen Baugruppe bereitgestellt. Bei dem Verfahren wird zunächst eine Leiterplatte bereitgestellt, beispielsweise ausgebildet, die Leiterbahnen, eine zentrale Ausnehmung und eine erste Kontaktausnehmung aufweist. Mindestens ein elektronisches Bauelement wird auf der zweiten Seite der Leiterplatte, die von der ersten Seite der Leiterplatte abgewandt ist, angeordnet und mit mindestens einer Leiterbahn der Leiterplatte elektrisch gekoppelt. Das Substrat wird bereitgestellt, das an der ersten Seite des Substrats den ersten Kontaktbereich aufweist. Das optoelektronische Bauelement wird auf der ersten Seite des Substrats angeordnet und ein erster Kontakt des optoelektronischen Bauelements wird mit dem ersten Kontaktbereich elektrisch gekoppelt. Die Leiterplatte wird an einer ersten Seite der Leiterplatte mit der ersten Seite des Substrats körperlich so gekoppelt, dass in der zentralen Ausnehmung der Leiterplatte das optoelektronische Bauelement frei gelegt ist und die erste Kontaktausnehmung den ersten Kontaktbereich überlappt. Das elektrisch leitfähige erste Verbindungselement wird in der ersten Kontaktausnehmung so angeordnet, dass es den ersten Kontaktbereich mit mindestens einer der Leiterbahnen elektrisch koppelt. Mit Hilfe des Verbindungselements wird das Substrat an der Leiterplatte festgelegt.

Gemäß verschiedenen Ausführungsformen wird für das Verbindungselement Lot verwendet. In anderen Worten wird das Verbindungselement von dem Lot gebildet.

Gemäß verschiedenen Ausführungsformen wird das Verbindungselement in die Kontaktausnehmung eingebracht und das Verbindungselement zum elektrischen Kontaktieren der Kontaktbereiche mit der Leiterbahn und zum Festlegen des Substrats an der Leiterplatte wird erwärmt. Beispielsweise kann das Lot in einem Dispensverfahren in die Kontaktausnehmung eingebracht werden. Das Lot kann beispielsweise Zinn und/oder Kupfer aufweisen.

Gemäß verschiedenen Ausführungsformen wird das Verbindungselement selektiv erwärmt. Beispielsweise kann das Lot selektiv erwärmt werden. In anderen Worten kann das Lot lokal erwärmt werden, so dass sich die umliegenden Komponenten, wie beispielsweise das Substrat oder die Leiterplatte lediglich lokal in der Nähe des Verbindungselements erwärmen und/oder sich das elektronische Bauelement und/oder das optoelektronische Bauelement lediglich geringfügig oder gar nicht erwärmen. Der selektive Lötprozess kann beispielsweise mittels eines Lasers durchgeführt werden, der beispielsweise auf das zu erwärmende Verbindungselement gerichtet wird.

Gemäß verschiedenen Ausführungsformen wird das Verbindungselement induktiv, mittels Mikrowellenstrahlung und/oder mittels eines Laserstrahls erwärmt.

Gemäß verschiedenen Ausführungsformen wird das Substrat mittels eines Haftmittels an der Leiterplatte festgelegt, beispielsweise befestigt. Dies kann dazu beitragen, eventuell auftretenden mechanischen Stress vorteilhaft auf die Leiterplatte und/oder das Substrat zu verteilen.

Ausführungsbeispiele der Erfindung sind in den Figuren dargestellt und werden im Folgenden näher erläutert.

Es zeigen:
- Figur 1: ein Ausführungsbeispiel einer optoelektronischen Baugruppe,
- Figur 2: eine Explosionsdarstellung der optoelektronischen Baugruppe gemäß Figur 1,
- Figur 3: eine Draufsicht auf ein Ausführungsbeispiel einer Leiterplatte,
- Figur 4: eine Draufsicht auf die Leiterplatte gemäß Figur 3 und ein Ausführungsbeispiel eines optoelektronischen Bauelements,
- Figur 5: eine perspektivische Schnittdarstellung der Leiterplatte und des optoelektronischen Bauelements gemäß Figur 4 mit einem Ausführungsbeispiel eines Substrats,
- Figur 6: eine Draufsicht auf eine Unterseite der Leiterplatte mit dem optoelektronischen Bauelement gemäß Figur 5,
- Figur 7: eine Schnittdarstellung auf ein Ausführungsbeispiel eines optoelektronischen Bauelements,
- Figur 8: eine perspektivische Ansicht einer Unterseite eines Ausführungsbeispiels einer optoelektronischen Baugruppe,
- Figur 9: eine Draufsicht auf eine Unterseite eines Ausführungsbeispiels einer optoelektronischen Baugruppe,
- Figur 10: ein Ablaufdiagramm eines Ausführungsbeispiels eines Verfahrens zum Herstellen einer optoelektronischen Baugruppe.

In der folgenden ausführlichen Beschreibung wird auf die beigefügten Zeichnungen Bezug genommen, die Teil dieser Beschreibung bilden und in denen zur Veranschaulichung spezifische Ausführungsbeispiele gezeigt sind, in denen die Erfindung ausgeübt werden kann. In dieser Hinsicht wird Richtungsterminologie wie etwa "oben", "unten", "vorne", "hinten", "vorderes", "hinteres", usw. mit Bezug auf die Orientierung der beschriebenen Figur(en) verwendet. Da Komponenten von Ausführungsbeispielen in einer Anzahl verschiedener Orientierungen positioniert werden können, dient die Richtungsterminologie zur Veranschaulichung und ist auf keinerlei Weise einschränkend. Es versteht sich, dass andere Ausführungsbeispiele benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen Ausführungsbeispiele miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

Im Rahmen dieser Beschreibung werden die Begriffe "verbunden", "angeschlossen" sowie "gekoppelt" verwendet zum Beschreiben sowohl einer direkten als auch einer indirekten Verbindung, eines direkten oder indirekten Anschlusses sowie einer direkten oder indirekten Kopplung. In den Figuren werden identische oder ähnliche Elemente mit identischen Bezugszeichen versehen, soweit dies zweckmäßig ist.

Eine optoelektronische Baugruppe kann ein, zwei oder mehr optoelektronische Bauelemente aufweisen. Optional kann eine optoelektronische Baugruppe auch ein, zwei oder mehr elektronische Bauelemente aufweisen.

Ein elektronisches Bauelement kann beispielsweise ein aktives und/oder ein passives elektronisches Bauelement aufweisen. Ein aktives elektronisches Bauelement kann beispielsweise eine Rechen-, Steuer- und/oder Regeleinheit und/oder einen Transistor aufweisen. Ein passives elektronisches Bauelement kann beispielsweise einen Kondensator, einen Widerstand, eine Diode oder eine Spule aufweisen.

Ein optoelektronisches Bauelement kann in verschiedenen Ausführungsbeispielen ein elektromagnetische Strahlung emittierendes Bauelement oder ein elektromagnetische Strahlung absorbierendes Bauelement aufweisen. Ein elektromagnetische Strahlung absorbierendes Bauelement kann beispielsweise eine Solarzelle sein. Ein elektromagnetische Strahlung emittierendes Bauelement kann in verschiedenen Ausführungsbeispielen ein elektromagnetische Strahlung emittierendes Halbleiter-Bauelement sein und/oder als eine elektromagnetische Strahlung emittierende Diode, als eine organische elektromagnetische Strahlung emittierende Diode, als ein elektromagnetische Strahlung emittierender Transistor oder als ein organischer elektromagnetische Strahlung emittierender Transistor ausgebildet sein. Die Strahlung kann beispielsweise Licht im sichtbaren Bereich, UV-Licht und/oder Infrarot-Licht sein. In diesem Zusammenhang kann das elektromagnetische Strahlung emittierende Bauelement beispielsweise als Licht emittierende Diode (light emitting diode, LED) als organische Licht emittierende Diode (organic light emitting diode, OLED), als Licht emittierender Transistor oder als organischer Licht emittierender Transistor ausgebildet sein. Das Licht emittierende Bauelement kann in verschiedenen Ausführungsbeispielen Teil einer integrierten Schaltung sein. Weiterhin kann eine Mehrzahl von Licht emittierenden Bauelementen vorgesehen sein, beispielsweise untergebracht in einem gemeinsamen Gehäuse. Ferner kann das optoelektronische Bauelement ein Substrat aufweisen, auf dem das elektromagnetische Strahlung emittierende Bauelement bzw. elektromagnetische Strahlung absorbierende Bauelement angeordnet ist.

Ein optoelektronisches Bauelement, das ein, zwei oder mehr Chips, beispielsweise Halbleiter-Chips, aufweist und ein Substrat, auf dem das optoelektronische Bauelement angeordnet ist, können beispielsweise als Untergruppe ("Submount") bezeichnet werden.

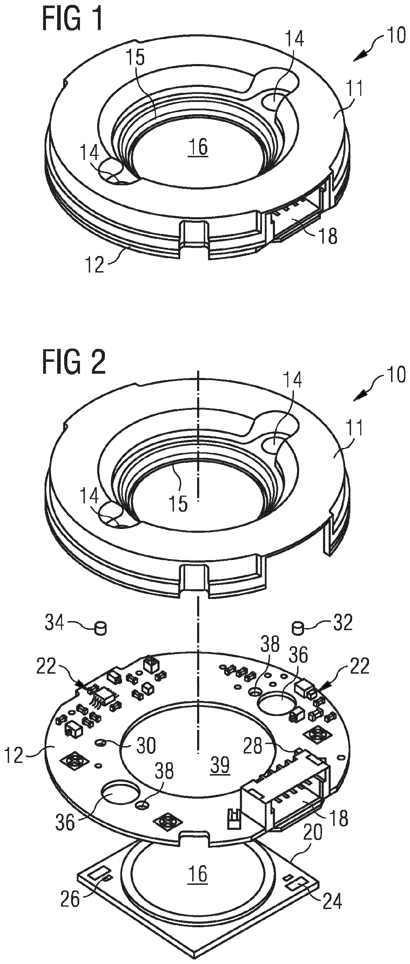

**Fig.1** zeigt eine perspektivische Darstellung eines Ausführungsbeispiels einer optoelektronischen Baugruppe 10. Die optoelektronische Baugruppe 10 kann beispielsweise gemäß dem Zhaga-Standard ausgebildet sein. Die optoelektronische Baugruppe 10 weist ein Gehäuse 11, eine Leiterplatte 12 und ein optoelektronisches Bauelement 16 auf. Das optoelektronische Bauelement 16 ist in einer zentralen Ausnehmung 15 des Gehäuses 11 freigelegt. Das optoelektronische Bauelement 16 kann elektromagnetische Strahlung durch die zentrale Ausnehmung 15 des Gehäuses 11 hindurch emittieren. Die Leiterplatte 12 kann beispielsweise mehrere elektrisch leitfähige Leiterbahnen aufweisen. Die Leiterplatte 12 kann beispielsweise eine herkömmliche Leiterplatte, beispielsweise eine FR1-, FR2-, FR3- , FR4-, FR5-, CEM1-, CEM2-, CEM3-, CEM4- oder CEM5-Leiterplatte sein, beispielsweise eine durchkontaktierte FR-4-Leiterplatte.

Das Gehäuse 11 weist zwei Montageausnehmungen 14 des Gehäuses 11 auf. Alternativ kann das Gehäuse 11 auch lediglich eine oder mehr Montageausnehmungen 14 des Gehäuses 11 aufweisen. Die optoelektronische Baugruppe 10 kann beispielsweise mittels der Montageausnehmungen 14 des Gehäuses 11 befestigt werden, beispielsweise an einer nicht dargestellten Montagefläche. Die Befestigung kann beispielsweise mittels Befestigungsmitteln erfolgen, beispielsweise mittels Schrauben.

Die optoelektronische Baugruppe 10 weist ein Steckerelement 18 (auch bezeichnet als Steckverbinderelement) auf, das beispielsweise zum elektrischen Kontaktieren der optoelektronischen Baugruppe 10 dienen kann. Beispielsweise kann die optoelektronische Baugruppe 10 mittels des Steckerelements 18 mit Energie versorgt und/oder gesteuert- oder geregelt werden.

**Fig. 2** zeigt eine Explosionsdarstellung der optoelektronischen Baugruppe 10 gemäß Figur 1. Die optoelektronische Baugruppe 10 weist ein Substrat 20 auf, auf dem ein, zwei oder mehr Chips, beispielsweise Halbleiterchips, beispielsweise LEDs angeordnet sind. Auf dem Substrat 20 sind ein erster Kontaktbereich 24 und/oder ein zweiter Kontaktbereich 26 zum elektrischen Kontaktieren des optoelektronischen Bauelements 16 ausgebildet.

Optional kann das optoelektronische Bauelement 16 eine Konversionsschicht aufweisen. Die Konversionsschicht kann beispielsweise auf einer von dem Substrat 20 abgewandten Seite des bzw. der Halbleiterchips angeordnet sein. Die Konversionsschicht kann beispielsweise zum Konvertieren elektromagnetischer Strahlung, die mittels der Chips erzeugt wird, dienen, beispielsweise bezüglich ihrer Wellenlängen. Beispielsweise kann die Konversionsschicht eine Leuchtstoff aufweisende Silikonschicht aufweisen.

Auf der Leiterplatte 12 sind beispielsweise ein, zwei oder mehr elektronische Bauelemente 22 angeordnet. Ferner sind die elektronischen Bauelemente 22 elektrisch mit den Leiterbahnen der Leiterplatte 12 gekoppelt. Die elektronischen Bauelemente 22 können beispielsweise passive oder aktive elektronischen Bauelemente aufweisen. Die aktiven elektronischen Bauelemente können beispielsweise eine Steuer- und/oder Regeleinheit und/oder einen Transistor aufweisen. Die passiven elektronischen Bauelemente können beispielsweise einen Widerstand, einen Kondensator und/oder eine Spule aufweisen. Die elektronischen Bauelemente 22 können beispielsweise mittels der Leiterbahnen (nicht dargestellt) der Leiterplatte 12 mit dem Steckerelement 18 elektrisch gekoppelt sein.

Die Leiterplatte 12 weist eine erste Kontaktausnehmung 28 und/oder eine zweite Kontaktausnehmung 30 und/oder eine zentrale Ausnehmung 39 der Leiterplatte 12 auf. Die erste Kontaktausnehmung 28 bildet bei bestimmungsgemäßem Anordnen der Leiterplatte 12 auf dem Substrat 20 mit dem ersten Kontaktbereich 24 einen Überlappungsbereich. In anderen Worten überlappen die erste Kontaktausnehmung 28 und der erste Kontaktbereich 24. Die zweite Kontaktausnehmung 30 und der zweite Kontaktbereich 26 bilden gegebenenfalls einen weiteren Überlappungsbereich. In anderen Worten überlappen die zweite Kontaktausnehmung 30 und der zweite Kontaktbereich 26.

In der ersten Kontaktausnehmung 28 kann ein erstes Verbindungselement 32 angeordnet werden. In der zweiten Kontaktausnehmung 30 kann gegebenenfalls ein zweites Verbindungselement 34 angeordnet werden. Die Verbindungselemente 32, 34 sind elektrisch leitfähig ausgebildet. Die Verbindungselemente 32, 34 dienen zum elektrischen Koppeln des entsprechenden Kontaktbereichs 24, 26 mit den elektronischen Bauelementen 22, dem optoelektronischen Bauelement 16 und/oder dem Steckerelement 18, beispielsweise mittels der Leiterbahnen der Leiterplatte 12. Darüber hinaus dienen die entsprechenden Verbindungselemente 32, 34 zum körperlichen Befestigen des Substrats 20 an der Leiterplatte 12. Die Leiterplatte 12 kann unmittelbar an dem Substrat 20 des optoelektronischen Bauelements 16 befestigt sein.

Die Leiterplatte 12 weist Montageausnehmungen 36 der Leiterplatte 12 auf, die bei bestimmungsgemäßer Anordnung des Gehäuses 11 auf der Leiterplatte 12 mit den entsprechenden Montageausnehmungen 14 des Gehäuses 11 überlappen. Beispielsweise können die Montageausnehmungen 36 der Leiterplatte 12 konzentrisch mit den Montageausnehmungen 14 des Gehäuses 11 ausgebildet sein und/oder den gleichen Radius aufweisen.

In der Leiterplatte 12 sind optionale Befestigungsausnehmungen 38 ausgebildet sein, die mit nicht dargestellten optionalen Befestigungsstiften, die an dem Gehäuse 11 ausgebildet sind, zusammenwirken. Beispielsweise können die Befestigungsstifte 11 mittels einer Presspassung in den Befestigungsausnehmungen 38 festgelegt sein, wodurch das Gehäuse 11 einfach an der Leiterplatte 12 befestigt werden kann.

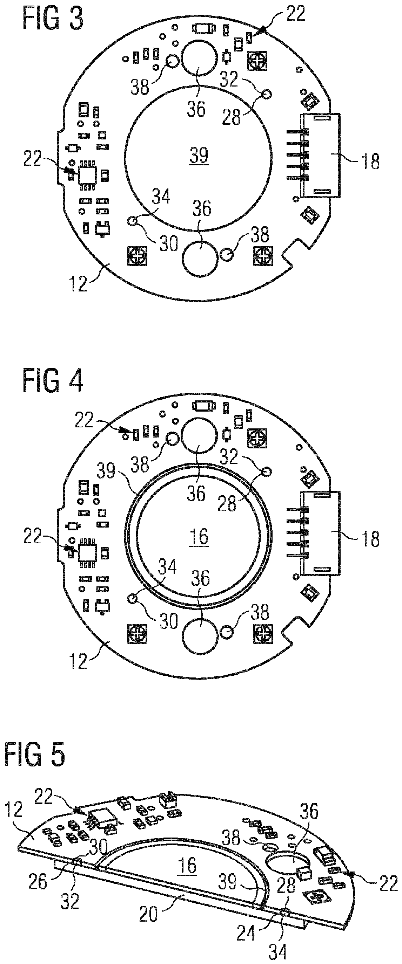

**Fig. 3** zeigt eine Draufsicht auf ein Ausführungsbeispiel einer Leiterplatte 12, die weitgehend der im Vorhergehenden erläuterten Leiterplatte 12 entsprechen kann. In der Leiterplatte 12 sind die Verbindungselemente 32, 34 angeordnet, beispielsweise in den Kontaktausnehmungen 28, 30. Die Leiterplatte 12 ist bei diesem Ausführungsbeispiel im Wesentlichen kreisrund ausgebildet. Alternativ dazu kann die Leiterplatte 12 beispielsweise polygonal, rechteckig oder quadratisch ausgebildet sein.

**Fig. 4** zeigt die Leiterplatte gemäß Figur 3 in Draufsicht mit einem Ausführungsbeispiel eines optoelektronischen Bauelements 16, wobei das optoelektronische Bauelement 16 weitgehend dem in Figur 2 gezeigten optoelektronischen Bauelement 16 entsprechen kann. Die in Figur 4 gezeigten Seiten der Leiterplatte 12 und des optoelektronischen Bauelements 16 können als Oberseite der Leiterplatte 12 bzw. des optoelektronischen Bauelements 16 bezeichnet werden. Ein elektromagnetische Strahlung emittierender Bereich des optoelektronischen Bauelements 16 ist in der zentralen Ausnehmung 39 der Leiterplatte 12 angeordnet. Beispielsweise sind elektromagnetische Strahlung emittierende Bauelemente des optoelektronischen Bauelements 16 in der zentralen Ausnehmung 39 der Leiterplatte 12 angeordnet. Ferner kann ggf. die Konversionsschicht zum Konvertieren der elektromagnetischen Strahlung bzgl. seiner Wellenlänge in der zentralen Ausnehmung 39 der Leiterplatte angeordnet sein. Ferner können die elektromagnetische Strahlung emittierenden Bauelemente des optoelektronischen Bauelements 16 über oder unter der zentralen Ausnehmung 39 der Leiterplatte 12 angeordnet sein.

**Fig. 5** zeigt eine perspektivische Schnittdarstellung der Leiterplatte 12, des Substrats 20 und des optoelektronischen Bauelements 16 gemäß Figur 4. Das Substrat 20 ist direkt körperlich mit den Verbindungselementen 32, 34 gekoppelt, und zwar in dem ersten bzw. zweiten Kontaktbereich 24, 26. Beispielsweise kann von den Verbindungselementen 32, 34 eine Lotverbindung zwischen der Leiterplatte 12 und dem Substrat 20, beispielsweise dem ersten bzw. zweiten Kontaktbereich 24, 26, gebildet sein. Eine erste Seite des Substrats 20 ist einer ersten Seite der Leiterplatte 12 zugewandt. Beispielsweise sind das Substrat 20 und die Leiterplatte 12 an ihren ersten Seiten in direktem körperlichen Kontakt zueinander angeordnet.

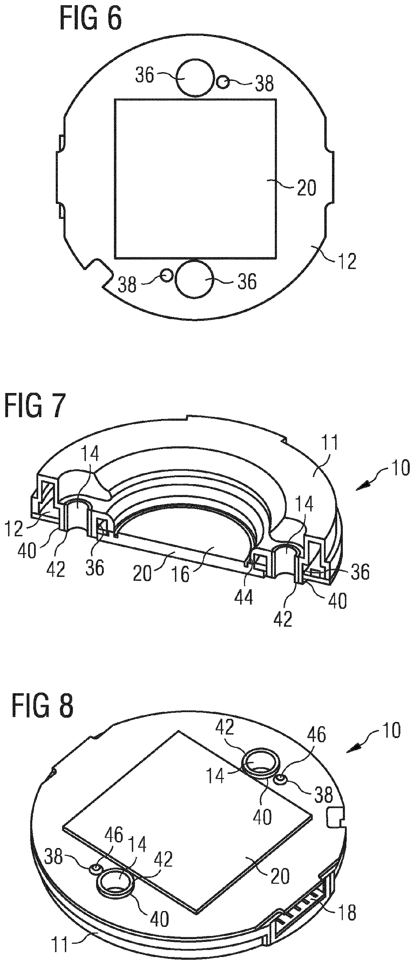

**Fig. 6** zeigt eine Draufsicht auf eine Unterseite eines Ausführungsbeispiels einer optoelektronischen Baugruppe 10, die weitgehend einer der im Vorhergehenden beschriebenen optoelektronischen Baugruppen 10 entsprechen kann. Die Unterseite der optoelektronischen Baugruppe 10 ist von einer Unterseite der Leiterplatte 12 und einer Unterseite des Substrats 20 gebildet. Die Unterseiten der Leiterplatte 12 bzw. des Substrats 20 sind von den Oberseiten der Leiterplatte 12 bzw. des Substrats 20 abgewandt. Die Unterseite der Untergruppe mit dem optoelektronischen Bauelement 16 ist von der Unterseite des Substrats 20 gebildet. Die Unterseite des Substrats 20 kann beispielsweise als zweite Seite des Substrats 20 bezeichnet werden und/oder ist von der ersten Seite des Substrats 20 abgewandt.

Das Substrat 20 ist quadratisch ausgebildet. Alternativ dazu kann das Substrat 20 auch anders ausgebildet sein, beispielsweise polygonal, beispielsweise rechteckig oder beispielsweise rundlich, beispielsweise oval oder kreisrund. Das Substrat 20 ist bzgl. der Montageausnehmungen 36 der Leiterplatte 12 so ausgebildet, dass die Montageausnehmungen 36 der Leiterplatte 12 und das Substrat 20 keinen Überlappungsbereich bilden.

**Fig. 7** zeigt eine perspektivische Schnittdarstellung eines Ausführungsbeispiels einer optoelektronischen Baugruppe 10, die weitgehend einer der im Vorhergehenden erläuterten optoelektronischen Baugruppen 10 entsprechen kann. Die Unterseite der optoelektronischen Baugruppe 10 ist entsprechend der Unterseite der optoelektronischen Baugruppe 10 gemäß Figur 6 ausgebildet. Die Montageausnehmungen 14 des Gehäuses 12 sind derart ausgebildet, dass sich Wandungen 40 der Montageausnehmungen 14 des Gehäuses 11 durch die Montageausnehmungen 36 der Leiterplatte 12 hindurch erstrecken, beispielsweise bis hin zu der Unterseite des Substrats 20.

Optional können in den Montageausnehmungen 14 des Gehäuses 11 Hülsen 42 angeordnet sein. Die Hülsen 42 können beispielsweise Metall aufweisen oder daraus gebildet sein. Die Hülsen können dazu beitragen, einen beim Befestigen der optoelektronischen Baugruppe 10 auftretenden mechanischen Stress, beispielsweise einen wirkenden Druck, zu kompensieren und/oder von dem Gehäuse 11 abzuleiten.

Die sich bis hin zu der zweiten Seite des Substrats 20 erstreckenden Wandungen 40 und/oder die Hülsen 42 können auf einfache Weise dazu beitragen, ein Entstehen von mechanischem Stress für die Leiterplatte 12 und/oder das Substrat 20 beim Befestigen der optoelektronischen Baugruppe 10 zu verhindern. Alternativ oder zusätzlich kann das Gehäuse 11 so ausgebildet sein, dass es einen Druckbereich 44 aufweist, der beispielsweise so ausgebildet ist, dass in dem Druckbereich 44 ein direkter körperlicher Kontakt zwischen dem Gehäuse und dem Substrat 20 besteht oder dass in dem Druckbereich 44 das Gehäuse 11 die Leiterplatte 12 gegen das Substrat 20 drückt.

**Fig. 8** zeigt eine perspektivische Ansicht der Unterseite der optoelektronischen Baugruppe 10, die weitgehend einer der im Vorhergehenden erläuterten optoelektronischen Baugruppen 10 entsprechen kann, beispielsweise der mit Bezug zu Figur 7 erläuterten optoelektronischen Baugruppe 10.

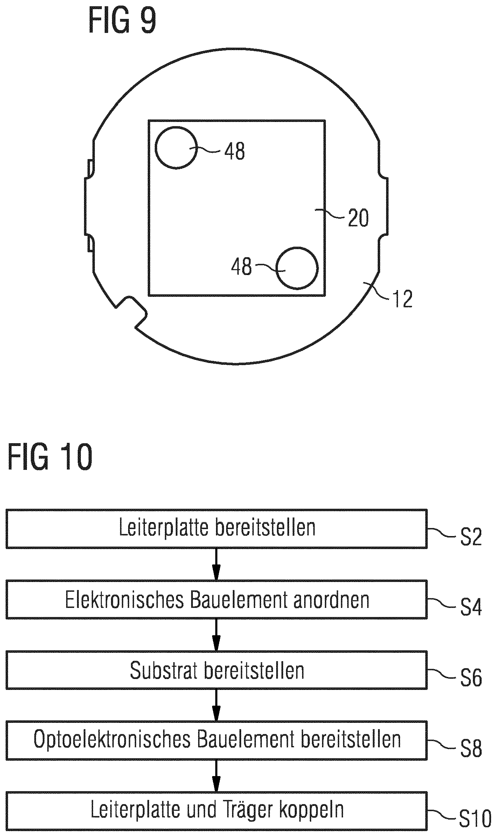

**Fig. 9** zeigt eine Draufsicht auf Unterseiten eines Ausführungsbeispiels einer Leiterplatte 12 und eines Ausführungsbeispiels des Substrats 20. Die Leiterplatte 12 und das Substrat 20 sind so zueinander ausgebildet und angeordnet, dass das Substrat 20 Montageausnehmungen 48 des Substrats 20 aufweist, die beispielsweise die Montageausnehmungen 36 der Leiterplatte 12 überlappen. Somit bilden die Montageausnehmungen 14 des Gehäuses 11, die Montageausnehmungen 36 der Leiterplatte 12 und die Montageausnehmungen 48 des Substrats 20 gemeinsame Montageausnehmungen der optoelektronischen Baugruppe 10. Dies kann dazu beitragen, auf die sich bis hin zu der Unterseite des Substrats 20 erstreckenden Wandungen 40 der Montageausnehmungen 14 des Gehäuses 11 und/oder die Hülsen 42 verzichten zu können und dennoch zu verhindern, dass beim Befestigen der optoelektronischen Baugruppe 10 an der Montagefläche ein mechanischer Stress auf die Leiterplatte 12 und/oder das Substrat 20 wirkt. Der mechanische Stress kann gegebenenfalls bewirken, dass die Leiterplatte 12 und/oder das Substrat 20 durchgebogen werden.

**Fig. 10** zeigt ein Ablaufdiagramm eines Ausführungsbeispiels eines Verfahrens zum Herstellen einer optoelektronischen Baugruppe, beispielsweise einer der im Vorhergehenden erläuterten optoelektronischen Baugruppen 10.

In einem Schritt S2 wird eine Leiterplatte, beispielsweise die im Vorhergehenden erläuterte Leiterplatte 12, bereitgestellt, beispielsweise ausgebildet. Die Leiterplatte 12 kann beispielsweise mit den Leiterbahnen, den Kontaktausnehmungen 28, 30, den Montageausnehmungen 36, der zentralen Ausnehmung 39 und/oder den Befestigungsausnehmungen 38 ausgebildet werden.

In einem Schritt S4 werden ein, zwei oder mehr elektronische Bauelemente, beispielsweise die im Vorhergehenden erläuterten elektronischen Bauelemente 22, auf der Leiterplatte 12 angeordnet. Beispielsweise können die elektronischen Bauelemente 22 körperlich und/oder elektrisch mit der Leiterplatte 12, beispielsweise den Leiterbahnen der Leiterplatte 12, verbunden werden. Die elektrische und/oder körperliche Verbindung kann beispielsweise mittels einer bzw. mehreren Lotverbindungen hergestellt werden.

In einem Schritt S6 wird ein Substrat bereitgestellt, beispielsweise das Substrat 20, das im Vorhergehenden erläutert wurde. Das Substrat 20 kann beispielsweise ein Kunststoffsubstrat, ein Keramiksubstrat oder ein Metallsubstrat sein.

In einem Schritt S8 wird ein optoelektronisches Bauelement, beispielsweise das im Vorhergehenden erläuterte optoelektronische Bauelement 16, bereitgestellt und/oder auf dem Substrat 20 angeordnet. Ferner können zwei, drei oder mehr optoelektronische Bauelemente 16 bereitgestellt werden. Beispielsweise können ein, zwei oder mehr Chips, beispielsweise Halbleiter-Chips auf dem Substrat 20 angeordnet oder ausgebildet werden. Ferner können die Kontaktbereiche 24, 26 auf dem Substrat 20 ausgebildet werden und elektrisch mit dem optoelektronischen Bauelement 16, beispielsweise den Chips, gekoppelt werden.

In einem Schritt S10 werden die Leiterplatte 12 und das Substrat 20 elektrisch und/oder körperlich miteinander gekoppelt, beispielsweise mit Hilfe der Verbindungselemente 32, 34. Die Verbindungselemente 32, 34 werden zum elektrischen Kontaktieren der Kontaktbereiche 24, 26 mit den Leiterbahnen und zum Festlegen des Substrats 20 an der Leiterplatte 12 in die Kontaktausnehmungen 28, 30 eingebracht und erwärmt. So kann das Lot in einem Dispensverfahren in die Kontaktausnehmungen 28, 30 eingebracht werden. Das Lot kann Zinn und/oder Kupfer aufweisen.

Die Verbindungselemente 32, 34 können selektiv erwärmt werden. So kann das Lot selektiv erwärmt werden. In anderen Worten kann das Lot lokal erwärmt werden, so dass sich die umliegenden Komponenten, wie beispielsweise das Substrat 20 oder die Leiterplatte 12 lediglich lokal in der Nähe der Verbindungselemente 32, 34 erwärmen und/oder sich das elektronische Bauelement 22 und/oder das optoelektronische Bauelement 16 lediglich geringfügig oder gar nicht erwärmen. Der selektive Lötprozess kann mittels eines Lasers durchgeführt werden, der auf das zu erwärmende Verbindungselement 32, 34 gerichtet wird. Alternativ oder zusätzlich können die Verbindungselemente induktiv, mittels Mikrowellenstrahlung und/oder mittels eines Laserstrahls erwärmt werden. Ferner kann das Substrat 20 vorgewärmt werden. Zusätzlich kann das Substrat 20 mittels eines Haftmittels an der Leiterplatte 12 festgelegt, beispielsweise befestigt, werden. Dies kann dazu beitragen, evtl. auftretenden mechanischen Stress vorteilhaft auf die Leiterplatte 12 und/oder das Substrat 20 zu verteilen.

Die Erfindung ist nicht auf die angegebenen Ausführungsbeispiele beschränkt. Beispielsweise kann die äußere Form der optoelektronischen Baugruppe 10 von der dargestellten Form abweichen. Ferner können bei allen Ausführungsbeispielen ein, zwei oder mehr Kontaktbereiche 24, 26, Kontaktausnehmungen 28, 30 und/oder Verbindungselemente 32, 34 angeordnet sein. Alternativ oder zusätzlich kann das optoelektronische Bauelement 16 weitere elektrische Kontakte aufweisen. Die Kontaktbereiche 24, 26 können bei allen Ausführungsbeispielen symmetrisch oder asymmetrisch angeordnet sein. Ferner können alternativ oder zusätzlich zum Löten die im Vorhergehenden erläuterten elektrischen und/oder körperlichen Verbindungen auch mittels Schweißen, beispielsweise mittels eines Schweißstroms, und/oder mittels einem, zwei oder mehr Federelementen ausgebildet werden. Ferner können bei allen Ausführungsbeispielen mehr optoelektronische Bauelemente 16 angeordnet sein. Beispielsweise kann ein optoelektronisches Bauelement 16 eine Vielzahl von lichtemittierenden Chips, beispielsweise Halbleiter-Chips, aufweisen. Ferner können mehr oder weniger Montageausnehmungen vorgesehen sein. Ferner können alle Ausführungsformen die Befestigungsstifte und die dazu korrespondierenden Befestigungsausnehmungen aufweisen. Alternativ dazu kann bei allen Ausführungsbeispielen auf die Befestigungsstifte und Befestigungsausnehmungen verzichtet werden und/oder das Gehäuse 11 kann beispielsweise mittels eines Haftmittels und/oder einer Klebeverbindung an der Leiterplatte 12 befestigt werden. Ferner können auf dem Substrat 20 ein, zwei oder mehr weitere Bauelemente, beispielsweise ein Oberflächenbauelement (Surface Mounted Device, SMD), angeordnet sein, wobei dann die Leiterplatte 22 entsprechend ein, zwei oder mehr weitere Ausnehmungen aufweisen kann, in denen beispielsweise die entsprechenden Bauelemente angeordnet sein können.

## Patentansprüche

1. Optoelektronische Baugruppe (10), mit
- einem Substrat (20), das an einer ersten Seite des Substrats (20) mindestens einen ersten Kontaktbereich (24) aufweist,
- einem optoelektronischen Bauelement (16), das auf der ersten Seite des Substrats (20) angeordnet ist und das einen ersten Kontakt, der mit dem ersten Kontaktbereich (24) elektrisch gekoppelt ist, aufweist,
- einer Leiterplatte (12), die Leiterbahnen aufweist und die an einer ersten Seite der Leiterplatte (12) mit der ersten Seite des Substrats (20) körperlich gekoppelt ist und die eine zentrale Ausnehmung (39) aufweist, in der das optoelektronische Bauelement (16) freigelegt ist, und die eine erste Kontaktausnehmung (28), die den ersten Kontaktbereich (24) überlappt, aufweist,
- mindestens einem elektronischen Bauelement (22), das auf einer zweiten Seite der Leiterplatte (12), die von der ersten Seite der Leiterplatte (12) abgewandt ist, angeordnet ist, und das mit mindestens einer der Leiterbahnen elektrisch gekoppelt ist,
- einem elektrisch leitfähigen ersten Verbindungselement (32), das in der ersten Kontaktausnehmung (28) angeordnet ist und den ersten Kontaktbereich (24) mit mindestens einer der Leiterbahnen elektrisch koppelt, wobei das Verbindungselement (32) das Substrat (20) an der Leiterplatte (12) festlegt.

2. Optoelektronische Baugruppe (10) nach Anspruch 1, mit einem Gehäuse (11), das zumindest einen Teil der zweiten Seite der Leiterplatte (12) abdeckt, das eine zentrale Ausnehmung (15) des Gehäuses (11) aufweist, in der das optoelektronische Bauelement (16) freigelegt ist, und das zum Befestigen der optoelektronischen Baugruppe (10) eine Montageausnehmung (14) des Gehäuses (11) aufweist, wobei die Leiterplatte (12) eine Montageausnehmung (36) der Leiterplatte (12) aufweist, die die
Montageausnehmung (14) des Gehäuses (11) zumindest teilweise überlappt.

3. Optoelektronische Baugruppe (10) nach Anspruch 2, bei der sich eine Wandung der Montageausnehmung (14) des Gehäuses (11) durch die Montageausnehmung (36) der Leiterplatte (12) hindurch und neben dem Substrat (20) bis hin zu einer zweiten Seite des Substrats (20) erstreckt, die von der ersten Seite des Substrats (20) abgewandt ist.

4. Optoelektronische Baugruppe (10) nach Anspruch 2, bei der die Leiterplatte (12) eine Montageausnehmung (36) der Leiterplatte (12) aufweist und bei der das Substrat (20) eine Montageausnehmung (48) des Substrats (20), die die Montageausnehmung (36) der Leiterplatte (12) überlappt, aufweist.

5. Optoelektronische Baugruppe (10) nach einem der Ansprüche 2 bis 4, bei der in der Montageausnehmung (14) des Gehäuses (11) eine Hülse (42) angeordnet ist.

6. Optoelektronische Baugruppe (10) nach einem der Ansprüche 2 bis 5, bei der das Gehäuse (11) einen Befestigungsstift (46) aufweist und die Leiterplatte (12) eine Befestigungsausnehmung (38) aufweist, wobei zumindest ein Abschnitt des Befestigungsstifts (46) in der Befestigungsausnehmung (38) angeordnet ist und wobei der Abschnitt des Befestigungsstifts (46) und die Befestigungsausnehmung (38) mit einer Presspassung zueinander ausgebildet sind.

7. Optoelektronische Baugruppe (10) nach einem der vorstehenden Ansprüche, bei der das Verbindungselement (32, 34) Lot aufweist.

8. Verfahren zum Herstellen einer optoelektronischen Baugruppe (10), bei dem
- eine Leiterplatte (12) bereitgestellt wird, die eine erste Seite, eine von der ersten Seite abgewandte zweite Seite, Leiterbahnen, eine zentrale Ausnehmung (39) der Leiterplatte (12), eine erste Kontaktausnehmung (28) aufweist,
- mindestens ein elektronisches Bauelement (22) auf der zweiten Seite der Leiterplatte (12) angeordnet wird und mit mindestens einer Leiterbahn der Leiterplatte (12) elektrisch gekoppelt wird,
- ein Substrat (20) bereitgestellt wird, das an einer ersten Seite des Substrats (20) einen ersten Kontaktbereich (24) aufweist,
- ein optoelektronisches Bauelement (16) auf der ersten Seite des Substrats (20) angeordnet wird und ein erster Kontakt des optoelektronischen Bauelements (16) mit dem ersten Kontaktbereich (24) elektrisch gekoppelt wird,
- die Leiterplatte (12) an einer ersten Seite der Leiterplatte (12) mit der ersten Seite des Substrats (20) körperlich so gekoppelt wird, dass in der zentralen Ausnehmung (39) der Leiterplatte (12) das optoelektronische Bauelement (16) frei gelegt ist und die erste Kontaktausnehmung (28) den ersten Kontaktbereich (24) überlappt,
- ein elektrisch leitfähiges erstes Verbindungselement (32) in der ersten Kontaktausnehmung (28) so angeordnet wird, dass es den ersten Kontaktbereich (24) mit mindestens einer der Leiterbahnen elektrisch koppelt, wobei mit Hilfe des Verbindungselements (32) das Substrat (20) an der Leiterplatte (12) festgelegt wird.

9. Verfahren nach Anspruch 8, bei dem für das Verbindungselement (32) Lot verwendet wird.

10. Verfahren nach einem der Ansprüche 8 oder 9, bei dem das Verbindungselement (32) in die Kontaktausnehmung (28) eingebracht wird und das Verbindungselement (32) zum elektrischen Kontaktieren des Kontaktbereichs (24) mit der Leiterbahn und zum Festlegen des Substrats (20) an der Leiterplatte (12) erwärmt wird.

11. Verfahren nach Anspruch 10, bei dem das Verbindungselement (32) selektiv erwärmt wird.

12. Verfahren nach Anspruch 11, bei dem das Verbindungselement (32) induktiv, mittels Mikrowellenstrahlung und/oder mittels eines Laserstrahls erwärmt wird.

13. Verfahren nach einem der Ansprüche 8 bis 12, bei dem das ubstrat (20) mittels eines Haftmittels an der Leiterplatte (12) festgelegt wird.

## Claims

1. Optoelectronic assembly (10), comprising
- a substrate (20), which has at least one first contact region (24) at a first side of the substrate (20),
- an optoelectronic component (16), which is arranged on the first side of the substrate (20) and which has a first contact electrically coupled to the first contact region (24),
- a printed circuit board (12), which has conductor tracks and which is physically coupled to the first side of the substrate (20) at a first side of the printed circuit board (12) and which has a central cutout (39), in which the optoelectronic component (16) is exposed, and which has a first contact cutout (28), which overlaps the first contact region (24),
- at least one electronic component (22) which is arranged on a second side of the printed circuit board (12), facing away from the first side of the printed circuit board (12), and which is electrically coupled to at least one of the conductor tracks,
- an electrically conductive first connection element (32), which is arranged in the first contact cutout (28) and electrically couples the first contact region (24) to at least one of the conductor tracks, wherein the connection element (32) fixes the substrate (20) to the printed circuit board (12).

2. Optoelectronic assembly (10) according to Claim 1, comprising a housing (11), which covers at least one part of the second side of the printed circuit board (12), which has a central cutout (15) of the housing (11), the optoelectronic component (16) being exposed in said central cutout, and which has a mounting cutout (14) of the housing (11) for the purpose of fixing the optoelectronic assembly (10), wherein the printed circuit board (12) has a mounting cutout (36) of the printed circuit board (12), which at least partly overlaps the mounting cutout (14) of the housing (11).

3. Optoelectronic assembly (10) according to Claim 2, wherein a wall of the mounting cutout (14) of the housing (11) extends through the mounting cutout (36) of the printed circuit board (12) and alongside the substrate (20) as far as a second side of the substrate (20), facing away from the first side of the substrate (20).

4. Optoelectronic assembly (10) according to Claim 2, wherein the printed circuit board (12) has a mounting cutout (36) of the printed circuit board (12) and wherein the substrate (20) has a mounting cutout (48) of the substrate (20), which overlaps the mounting cutout (36) of the printed circuit board (12).

5. Optoelectronic assembly (10) according to any of Claims 2 to 4, wherein a sleeve (42) is arranged in the mounting cutout (14) of the housing (11).

6. Optoelectronic assembly (10) according to any of Claims 2 to 5, wherein the housing (11) has a fixing pin (46) and the printed circuit board (12) has a fixing cutout (38), wherein at least one section of the fixing pin (46) is arranged in the fixing cutout (38) and wherein the section of the fixing pin (46) and the fixing cutout (38) are embodied with a press fit with respect to one another.

7. Optoelectronic assembly (10) according to any of the preceding claims, wherein the connection element (32, 34) comprises solder.

8. Method for producing an optoelectronic assembly (10), wherein
- a printed circuit board (12) is provided, which has a first side, a second side facing away from the first side, conductor tracks, a central cutout (39) of the printed circuit board (12), a first contact cutout (28),
- at least one electronic component (22) is arranged on the second side of the printed circuit board (12) and is electrically coupled to at least one conductor track of the printed circuit board (12),
- a substrate (20) is provided, which has a first contact region (24) at a first side of the substrate (20),
- an optoelectronic component (16) is arranged on the first side of the substrate (20) and a first contact of the optoelectronic component (16) is electrically coupled to the first contact region (24),
- the printed circuit board (12) is physically coupled to the first side of the substrate (20) at a first side of the printed circuit board (12) such that the optoelectronic component (16) is exposed in the central cutout (39) of the printed circuit board (12) and the first contact cutout (28) overlaps the first contact region (24),
- an electrically conductive first connection element (32) is arranged in the first contact cutout (28) such that it electrically couples the first contact region (24) to at least one of the conductor tracks, wherein the substrate (20) is fixed to the printed circuit board (12) with the aid of the connection element (32).

9. Method according to Claim 8, wherein solder is used for the connection element (32).

10. Method according to either of Claims 8 and 9, wherein the connection element (32) is introduced into the contact cutout (28) and the connection element (32) is heated for the purpose of electrically contacting the contact region (24) to the conductor track and for the purpose of fixing the substrate (20) to the printed circuit board (12).

11. Method according to Claim 10, wherein the connection element (32) is selectively heated.

12. Method according to Claim 11, wherein the connection element (32) is heated inductively, by means of microwave radiation and/or by means of a laser beam.

13. Method according to any of Claims 8 to 12, wherein the substrate (20) is fixed to the printed circuit board (12) by means of an adhesive.

## Revendications

1. Sous-ensemble optoélectronique (10) comportant :
- un substrat (20) qui présente au moins une première zone de contact (24) sur un premier côté du substrat (20) ;
- un composant optoélectronique (16) qui est agencé sur le premier côté du substrat (20) et qui présente un premier contact couplé électriquement à la première zone de contact (24) ;
- une carte de circuit imprimé (12) qui comporte des pistes conductrices, qui est couplée physiquement au premier côté du substrat (20) sur un premier côté de la carte de circuit imprimé (12), qui présente un évidement central (39) dans lequel le composant optoélectronique (16) est dégagé et qui présente un premier évidement de contact (28) en chevauchement avec la première zone de contact (24) ;
- au moins un composant électronique (22) agencé sur un deuxième côté de la carte de circuit imprimé (12) qui est opposé au premier côté de la carte de circuit imprimé (12) et couplé électriquement à au moins l'une des pistes conductrices ;
- un premier élément de liaison (32) électriquement conducteur qui est agencé dans le premier évidement de contact (28) et qui couple électriquement la première zone de contact (24) à au moins l'une des pistes conductrices, l'élément de liaison (32) fixant le substrat (20) sur la carte de circuit imprimé (12).

2. Sous-ensemble optoélectronique (10) selon la revendication 1, comportant un boîtier (11) qui recouvre au moins une partie du deuxième côté de la carte de circuit imprimé (12), qui présente un évidement central (15) du boîtier (11) dans lequel le composant optoélectronique (16) est dégagé et qui présente un évidement de montage (14) du boîtier (11) pour la fixation du sous-ensemble optoélectronique (10), la carte de circuit imprimé (12) présentant un évidement de montage (36) de la carte de circuit imprimé (12) qui est au moins partiellement en chevauchement avec l'évidement de montage (14) du boîtier (11).

3. Sous-ensemble optoélectronique (10) selon la revendication 2, dans lequel une paroi de l'évidement de montage (14) du boîtier (11) traverse l'évidement de montage (36) de la carte de circuit imprimé (12) de part en part et longe le substrat (20) jusqu'à un deuxième côté du substrat (20) qui est opposé au premier côté du substrat (20).

4. Sous-ensemble optoélectronique (10) selon la revendication 2, selon lequel la carte de circuit imprimé (12) présente un évidement de montage (36) de la carte de circuit imprimé (12) et selon lequel le substrat (20) présente un évidement de montage (48) du substrat (20) en chevauchement avec l'évidement de montage (36) de la carte de circuit imprimé (12).

5. Sous-ensemble optoélectronique (10) selon l'une des revendications 2 à 4, selon lequel une douille (42) est agencée dans l'évidement de montage (14) du boîtier (11).

6. Sous-ensemble optoélectronique (10) selon l'une des revendications 2 à 5, selon lequel le boîtier (11) comporte une tige de fixation (46) et la carte de circuit imprimé (12) comporte un évidement de fixation (38), au moins une section de la tige de fixation (46) étant située dans l'évidement de fixation (38) et la section de la tige de fixation (46) et l'évidement de fixation (38) étant réalisés avec un ajustement serré entre eux.

7. Sous-ensemble optoélectronique (10) selon l'une des revendications précédentes, selon lequel l'élément de liaison (32, 34) comporte un alliage d'apport.

8. Procédé de fabrication d'un sous-ensemble optoélectronique (10), dans lequel
- est fournie une carte de circuit imprimé (12) qui présente un premier côté, un deuxième côté opposé au premier côté, des pistes conductrices, un évidement central (39) de la carte de circuit imprimé (12), un premier évidement de contact (28) ;
- au moins un composant électronique (22) est agencé sur le deuxième côté de la carte de circuit imprimé (12) et est couplé électriquement à au moins une piste conductrice de la carte de circuit imprimé (12) ;
- est fourni un substrat (20) qui présente une première zone de contact (24) sur un premier côté du substrat (20) ;
- un composant optoélectronique (16) est agencé sur le premier côté du substrat (20) et un premier contact du composant optoélectronique (16) est couplé électriquement à la première zone de contact (24) ;
- la carte de circuit imprimé (12) est couplée physiquement, sur un premier côté de la carte de circuit imprimé (12), au premier côté du substrat (20) de telle sorte que, dans l'évidement central (39) de la carte de circuit imprimé (12), le composant optoélectronique (16) est dégagé et le premier évidement de contact (28) est en chevauchement avec la première zone de contact (24) ;
- un premier élément de liaison (32) électriquement conducteur est agencé dans le premier évidement de contact (28) de manière à coupler électriquement la première zone de contact (24) à au moins l'une des pistes conductrices,
le substrat (20) étant fixé sur la carte de circuit imprimé (12) à l'aide de l'élément de liaison (32).

9. Procédé selon la revendication 8, dans lequel un alliage d'apport est utilisé pour l'élément de liaison (32).

10. Procédé selon l'une des revendications 8 ou 9, dans lequel l'élément de liaison (32) est introduit dans l'évidement de contact (28) et l'élément de liaison (32) est chauffé pour établir le contact électrique entre la zone de contact (24) et la piste conductrice et pour fixer le substrat (20) sur la carte de circuit imprimé (12).

11. Procédé selon la revendication 10, dans lequel l'élément de liaison (32) est chauffé sélectivement.

12. Procédé selon la revendication 11, dans lequel l'élément de liaison (32) est chauffé par induction, au moyen d'un rayonnement micro-onde et/ou au moyen d'un faisceau laser.

13. Procédé selon l'une des revendications 8 à 12, dans lequel le substrat (20) est fixé sur la carte de circuit imprimé (12) au moyen d'un agent adhésif.
